# EUROPEAN PATENT APPLICATION

(11) **EP 1 801 852 A1**
(43) Date of publication of application: **27.06.2007**
(21) Application number: 05765637.3
(22) Date of filing: 14.07.2005
(51) Int. Cl.: H01L 21/027, G02B 7/00, G02B 7/02, G03F 7/20

(54) **SUPPORT METHOD AND SUPPORT STRUCTURE FOR OPTICAL MEMBER, OPTICAL APPARATUS, EXPOSURE APPARATUS, AND DEVICE PRODUCTION METHOD**

(30) Priority: 16.07.2004 JP 2004209941
(71) Applicant: NIKON CORPORATION, Tokyo 100-8831 (JP)
(72) Inventor: SHIBAZAKI, Yuichi, c/o NIKON CORPORATION, Tokyo 1008331 (JP)
(74) Representative: Gill, David Alan
(86) International application number: PCT/JP2005/013030
(87) International publication number: WO 2006/009064

(57) **Abstract**

A spacer member (93) is placed between a lens (92) that is located at the lowermost end among a plurality of lenses and a parallel flat plate (94) that is placed below the lens, and the lens (92) is made to support by suspension the parallel flat plate by sucking a part of the lens (92) and the parallel flat plate. Accordingly, the spacer member (93) does not need to be larger than the parallel flat plate (94) and the space in the vicinity of the parallel flat plate (94) can be secured, compared with the case where a holding mechanism that holds the parallel flat plate (94) by grasping it is employed. Further, since the parallel flat plate (94) is not grasped, deformation of the parallel flat plate (94) can be avoided, which can suppress occurrence of aberration in a projection unit (PU).

## Description

The present invention relates to support methods and support structures of optical members, optical units, exposure apparatuses and device manufacturing methods, and more particularly, to a support method and a support structure of an optical member that are suitable for making an optical member such as a lens support another optical member, an optical unit in which the support structure is employed as a part thereof, an exposure apparatus that comprises the optical unit, and a device manufacturing method in which a device pattern is transferred onto an object using the exposure apparatus.

Conventionally, in a lithographic process for manufacturing electron devices such as semiconductor devices (integrated circuits and the like) and liquid crystal display devices, exposure apparatuses such as a reduction projection exposure apparatus by a step-and-repeat method (the so-called stepper) that transfers an image of a pattern of a mask (or a reticle) to each of a plurality of shot areas on a photosensitive object such as a wafer or a glass plate coated with resist (photosensitive agent) (hereinafter referred to as a 'wafer') via a projection optical system, or a projection exposure apparatus by a step-and-scan method (the so-called scanning stepper (which is also called a scanner)) are mainly used.

In these types of projection exposure apparatuses, a higher resolving power (resolution) is required year by year to cope with finer patterns due to higher integration of integrated circuits, which has gradually encouraged a shorter wavelength of exposure light and an increase in numerical aperture (NA) (a larger NA) of the projection optical system. However, although such shorter wavelength of the exposure light and large NA of the projection optical system improve the resolution of the projection exposure apparatus, it also causes a decrease in depth of focus. Further, it is presumed that the exposure wavelength will become much shorter in the future, and if the situation continues, the depth of focus could become so small that focus margin shortage would occur during the exposure operation.

Therefore, as a method of substantially shortening the exposure wavelength while increasing (widening) the depth of focus when compared with the depth of focus in the air, an exposure apparatus that uses the liquid immersion method is recently gathering attention. As such an exposure apparatus using the liquid immersion method, the apparatus that performs exposure in a state where a liquid immersion area (a local area that is filled with water, an organic solvent or the like) is formed between the lower end surface of a projection optical system, that is, the lower surface of an optical member located at the end of the projection optical system that faces a wafer and the wafer surface is known (for example, refer to Patent Document 1 below). According to the exposure apparatus of Patent Document 1, the resolution is improved by making use of the fact that the wavelength of an exposure light in the liquid becomes 1/n of the wavelength in the air ('n' is the refractive index of the liquid which is normally around 1.2 to 1.6), and the depth of focus can also be increased n times when compared with the case where the same resolution is obtained by a projection optical system (supposing that such a projection optical system can be made) that does not employ the liquid immersion method, that is, the depth of focus can be substantially increased n times compared with the depth of focus in the air.

Meanwhile, in the liquid immersion exposure apparatus, since the lower surface of an end optical member is directly in contact with a liquid (such as water), the end optical member needs to be exchanged relatively frequently in order to prevent decrease in exposure accuracy due to adherence of resist to the lower surface of the optical member or trace of liquid caused by repeating supply and recovery of the liquid. Taking such a point into consideration, in a conventional projection exposure apparatus, a mechanism that is made of, for example, metals or the like and mechanically grasps the end optical member is arranged at the lower end of a barrel of the projection optical system and the mechanism holds the end optical member freely detachable with respect to the barrel.

However, in the case the end optical member is held using the mechanism as described above, since a center portion of the end optical member serves as an optical path, the mechanism grasps (holds) an outer edge portion of the end optical member by necessity, and a part of the mechanism inevitably protrudes to the outside of the end optical member, which makes a size of the mechanism larger than that of the end optical member. Therefore, for example, in the case of a liquid immersion exposure apparatus, a nozzle used to form a liquid immersion area between the lower surface of the end optical member and the wafer surface is expelled to the outside of the grasp mechanism of the optical member (i.e. the outside of the projection optical system). This means that the liquid immersion area is increased in size. The increase in size of the liquid immersion area means that an area substantially flush with the wafer surface is needed around the wafer, and as a consequence, a size of a table that holds the wafer increases, which leads to difficulty in position control of the table. Further, in the case a height position of the wafer surface in a projection area of an illumination light by the projection optical system is detected by, for example, a sensor by an optical method, the sensor has to be placed at a position apart from the projection optical system. Thus, to employ a mechanism that mechanically grasps the end optical member contributes to the increase in size of the exposure apparatus.

Further, in the case a mechanism that mechanically grasps the end optical member is employed, deformation of the end optical member could occur, which generates the possibility that image-forming performance of the projection optical system deteriorates. Moreover, there is also the possibility that metal ion of the metals that make up the mechanical mechanism is eluted into a liquid, which decreases exposure accuracy.

Since the adherence of resist droplets to the end optical member described above occurs also in a projection exposure apparatus that does not employ the liquid immersion method, in such an apparatus, a mechanism that mechanically grasps the end optical member described above is arranged at the lower end of a barrel of a projection optical system and the mechanism holds the end optical member freely detachable with respect to the barrel. Accordingly, the problems that occur when the mechanism that mechanically grasps the end optical member is employed exist also in a normal projection exposure apparatus, except for the problems peculiar to the liquid immersion.

For the reason, the emergence of a new technology is expected that can support the end optical member without protruding to the outside of the end optical member.

Patent Document 1: the pamphlet of International Publication No. WO99/49504.

The present invention has been made in consideration of the situation described above, and according to a first aspect of the present invention, there is provided a support method of an optical member, comprising: disposing a spacer member between a first optical member and a second optical member; and making the first optical member support the second optical member via the spacer member by sucking at least one of at least a part of a periphery portion of the first optical member and at least a part of a periphery portion of the second optical member by the spacer member.

In the present description, at least a part of a periphery portion of an optical member is a concept that includes, as a matter of course, at least a part of a periphery portion of an optical element in the case the optical member is made up of only the optical element, and also includes a part of another member in the case the optical member has an optical element and another member that is integrally attached to the periphery portion of the optical element. Further, in the present description, the suction includes vacuum suction as a matter of course, and also includes suction by a magnetic force, suction by an electrostatic force or the like.

In this method, the second optical member is supported by the first optical member via the spacer member that is disposed between the first optical member and the second optical member and sucks at least one of at least a part of a periphery portion of the first optical member and at least a part of a periphery portion of the second optical member. In this case, since the spacer member can be configured to suck, for example, at least a part of the surfaces facing each other of the first optical member and the second optical member, the spacer member can be configured not protrude to the outside of the first optical member and the second optical member. Accordingly, for example, in the case the second optical member is the optical member (the end optical member) of the projection optical system that faces a wafer described above, the end optical member can be supported without protruding the spacer member to the outside. Further, the space in the vicinity of the second optical member can be secured. Also, since the support method makes use of a vacuum suction force or other suction forces, deformation of the second optical member can be suppressed. Further, because the second optical member can be detached without difficulty by releasing the suction force, the exchange can be performed easily.

According to a second aspect of the present invention, there is provided a support structure of an optical member, comprising: a spacer member that is disposed between a periphery portion of a first optical member and a periphery portion of a second optical member, and makes the first optical member support the second optical member by sucking at least one of at least a part of a periphery portion of the first optical member and at least a part of a periphery portion of the second optical member.

This support structure comprises the spacer member that is disposed between a periphery portion of the first optical member and a periphery portion of the second optical member, and makes the first optical member support the second optical member by sucking at least one of at least a part of a periphery portion of the first optical member and at least a part of a periphery portion of the second optical member. In this case, since the spacer member can be configured to suck, for example, at least a part of the surfaces facing each other of the first optical member and the second optical member, the spacer member can be configured not to protrude to the outside of the first optical member and the second optical member. Accordingly, for example, in the case the second optical member is the optical member (the end optical member) of the projection optical system that faces a wafer described above, the end optical member can be supported without protruding the spacer member to the outside. Further, the space in the vicinity of the second optical member can be secured. Also, since the support structure makes use of a vacuum suction force or other suction forces, deformation of the second optical member can be suppressed. Further, because the second optical member can be detached without difficulty by releasing the suction force, the exchange can be performed easily.

According to a third aspect of the present invention, there is provided an optical unit that is configured including a plurality of optical members, the unit comprising: a spacer member that is placed between a periphery portion of a first optical member and a periphery portion of a second optical member among the plurality of optical members, and makes the first optical member support the second optical member by sucking at least one of at least a part of a periphery portion of the first optical member and at least a part of a periphery portion of the second optical member.

With this unit, the second optical member is supported by the first optical member via the spacer member that is disposed between a periphery portion of the first optical member and a periphery portion of the second optical member among the plurality of optical members, and sucks at least one of at least a part of a periphery portion of the first optical member and at least a part of a periphery portion of the second optical member. In this case, since the spacer member can be configured to suck, for example, at least a part of the surfaces facing each other of the first optical member and the second optical member, the spacer member can be configured not to protrude to the outside of the first optical member and the second optical member. Accordingly, for example, in the case the second optical member is the optical member (the end optical member) of the projection optical system that faces a wafer described above, the end optical member can be supported without protruding the spacer member to the outside. Further, the space in the vicinity of the second optical member can be secured. Also, since the support method makes use of a vacuum suction force or other suction forces, deformation of the second optical member can be suppressed. Further, because the second optical member can be detached without difficulty by releasing the suction force, the exchange can be performed easily.

According to a fourth aspect of the present invention, there is provided an exposure apparatus that projects an image of a predetermined pattern on an object, the apparatus comprising: a stage on which the object is mounted; and the optical unit of the present invention that projects an image of the pattern on the object

Since this exposure apparatus comprises the optical unit of the present invention that projects an image of a pattern formed on a mask onto an object, deformation of the second optical member is suppressed and also the exchange of the second optical member can be performed without difficulty. Accordingly, the optical performance of the second optical member can be favorably maintained for a long period, which makes it possible to maintain exposure accuracy with high precision. Further, for example, in the case the second optical member is an optical member (an end optical member) of the projection optical system that faces a wafer, since the space in the vicinity of the second optical member is secured, a member needed when performing exposure can be placed in the vicinity of the projection optical system, thereby downsizing the entire exposure apparatus.

In this case, the exposure apparatus can further comprise a liquid immersion unit that forms a liquid immersion area that is filled with a liquid between the second optical member and the object. In such a case, since the space in the vicinity of the second optical member is secured, the liquid immersion unit can be placed close to the vicinity of the second optical member, thereby reducing the liquid immersion area in size. Since this makes it possible to downsize the stage that holds the object, position controllability of the stage is improved and also from this point, exposure accuracy can be improved.

Further, in a lithography process, since a device pattern is transferred onto an object using the exposure apparatus of the present invention, a fine pattern can be transferred onto the object with good accuracy. Accordingly, it can also be said from another aspect that the present invention is a device manufacturing method including a process in which a device pattern is transferred onto an object using the exposure apparatus of the present invention.
FIG. 1 is a schematic view showing an exposure apparatus related to an embodiment of the present invention.
FIG. 2 is a longitudinal section view of the vicinity of the lower end portion of a projection optical system.
FIG. 3A is a perspective view showing a state of a spacer member viewed from above.
FIG. 3B is a perspective view showing a state of the spacer member viewed from below.
FIG. 4 is a longitudinal section view of the spacer member.
FIG. 5A is a view showing an inner structure of an annular member and a configuration of a liquid immersion unit.
FIG. 5B is a bottom plan view of the annular member.
FIG. 6 is a view used to explain the operation of the liquid immersion unit.

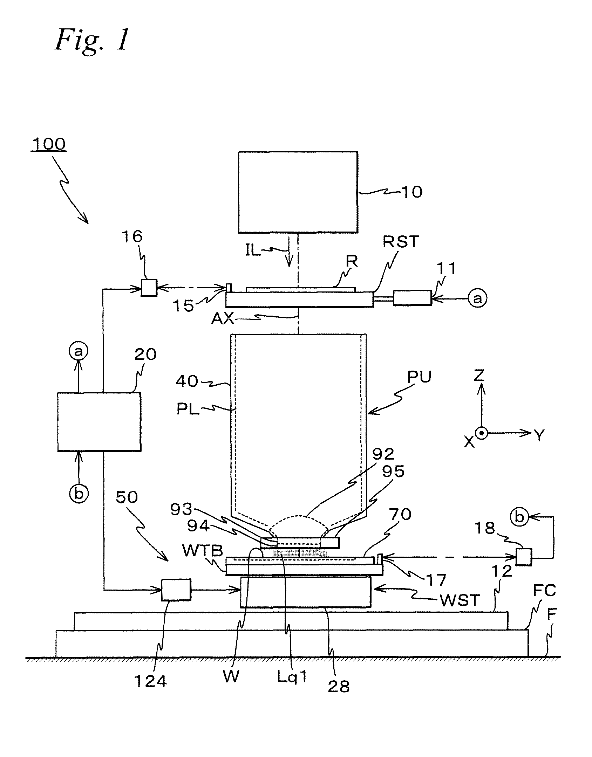

An embodiment of the present invention will be described below, referring to FIGS. 1 to 6.

FIG. 1 shows the schematic configuration of an exposure apparatus 100 of an embodiment. Exposure apparatus 100 is a projection exposure apparatus by a step-and-scan method, that is, the so-called scanning stepper (which is also called scanner). Exposure apparatus 100 is equipped with an illumination system 10, a reticle stage RST that holds a reticle R as a mask, a projection unit PU as an optical unit, a stage unit 50 that has a wafer stage WST as a stage, their control system, and the like. On wafer stage WST, a wafer W as an object is mounted.

Illumination system 10 is configured including a reticle blind and the like (none of which is shown). Illumination system 10 illuminates an illumination light (an exposure light) IL as an energy beam to a slit-shaped illumination area extending in an X-axis direction on reticle R that is set by the reticle blind with substantially uniform illuminance. In this case, as illumination light IL, an ArF excimer laser beam (wavelength: 193nm) is used as an example.

On reticle stage RST, reticle R, which has a pattern surface (the lower surface in FIG. 1) on which a circuit pattern or the like is formed, is fixed, for example, by vacuum suction. Reticle stage RST is finely drivable within an XY plane that is perpendicular to an optical axis of illumination system 10 (which coincides with an optical axis AX of a projection optical system PL to be described later) and also drivable in a predetermined scanning direction (in this case, to be a Y-axis direction being a horizontal direction of the page surface of FIG. 1) with a designated scanning velocity by a reticle stage drive section 11, for exmpale, including a liner motor or the like.

The position of reticle stage RST within a stage-moving plane (including a rotation around a Z-axis) is constantly detected at a resolution of, for example, around 0.5 to 1 nm with a reticle laser interferometer (hereinafter referred to as a reticle interferometer') 16 via a movable mirror 15. Incidentally, as a movable mirror 15 in actual, a Y movable mirror having a reflection surface orthogonal to the Y-axis direction and an X movable mirror having a reflection surface orthogonal to the X-axis direction are arranged. Measurement values of reticle interferometer 16 are sent to main controller 20, and main controller 20 computes the position of reticle stage RST in the X-axis direction, the Y-axis direction and a θz direction (a rotation direction around the Z-axis), and also controls the position (and the velocity) of reticle stage RST by controlling reticle stage drive section 11 based on the computation results.

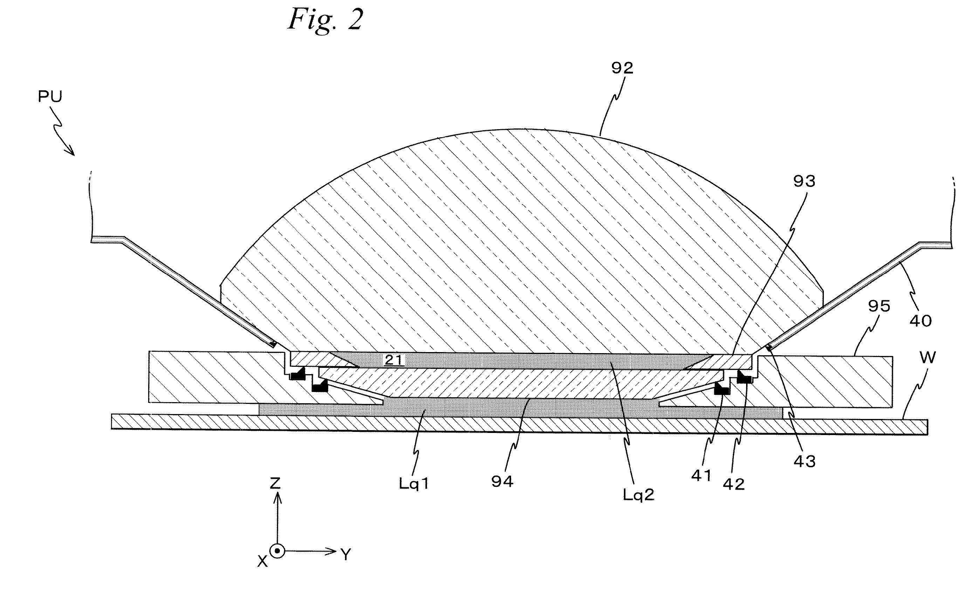

Projection unit PU is placed below reticle stage RST in FIG. 1. Projection unit PU is configured including a barrel 40 and projection optical system PL that is configured including a plurality of optical elements that are held within barrel 40 having a predetermined relation and a parallel flat plate 94 (not shown in FIG. 1, refer to FIG. 2) that faces a wafer. In the embodiment, as projection optical system PL, for example, a dioptric system that includes a plurality of lenses (lens elements) sharing optical axis AX in the Z-axis direction and parallel flat plate 94 is used.

As is shown in FIG. 2 that is a section view showing the vicinity of a lower end portion of projection unit PU, parallel flat plate 94 is supported via a spacer member 93, below a lens 92 that serves as a first optical member being located at the lowermost end among a plurality of lenses inside barrel 40 of projection unit PU.

Further, as can be seen from FIG. 2, the space between lens 92 and parallel flat plate 94 is filled with a liquid Lq2 that transmits an ArF excimer leaser beam (light with a wavelength of 193nm) and has a refractive index greater than one.

In the embodiment, projection optical system PL that is constituted by a both-side telecentric dioptric system having a predetermined projection magnification (e.g. 1/4 or 1/5) is substantially configured containing a plurality of lenses including lens 92 inside barrel 40, water Lq2 and parallel flat plate 94.

Further, a liquid Lq1 that transmits an ArF excimer leaser beam and has a refractive index greater than one, i.e. the same liquid as liquid Lq2 is supplied to the space between parallel flat plate 94 and wafer W.

Therefore, when an illumination area on reticle R is illuminated by illumination light IL from illumination system 10, illumination light IL having passed through reticle R forms a reduced image of a circuit pattern (a reduced image of a part of the circuit pattern) within the illumination area on an irradiation area of illumination light IL, which is conjugate with the illumination area, on a wafer which surface is coated with resist (photosensitive agent), via projection optical system PL and liquid Lq1.

Incidentally, in exposure apparatus 100 of the embodiment, since exposure applying the liquid immersion method is performed, when the numerical aperture NA substantially becomes larger, the opening on the reticle side increases in size. Therefore, in a dioptric system made up of only lenses, it becomes difficult to satisfy the Petzval condition, which tends to increase in size of the projection optical system. In order to avoid such an increase in size of the projection optical system, a catadioptric system configured including mirrors and lenses may also be used.

Incidentally, the configuration in the vicinity of the lower end portion of projection optical system PL including spacer member 93 and the like, and the configuration of a liquid immersion unit that performs supply of liquid Lq1 and Lq2 and the like will be described later.

Referring back to FIG. 1, stage unit 50 is equipped with a frame caster FC, a base board 12 that is arranged on frame caster FC via a vibration isolation mechanism (not shown), wafer stage WST that is placed above the upper surface of base board 12, a stage drive section 124 that drives wafer stage WST, and the like.

Base board 12 is made up of a plate-like member that is also called a platform, and the upper surface of base board 12 is processed so as to have an extremely high degree of flatness, and serves as a guide surface when moving a wafer stage WST.

As is shown in FIG. 1, wafer stage WST is placed on base board 12, and is equipped with a wafer stage main section 28 that is movable within a two-dimensional plane by a liner motor or the like, and a wafer table WTB that is mounted on wafer stage main section 28 via a Z/tilt drive mechanism (not shown). In actual, the Z/tilt drive mechanism is configured including three actuators (e.g. voice coil motors or EI cores) that support wafer table WTB at three points on wafer stage main section 28, and finely drives wafer table WTB in directions of three degrees of freedom that are the Z-axis direction, a θx direction (a rotation direction around an X-axis) and a θy direction (a rotation direction around a Y-axis).

On wafer table WTB, a wafer holder 70 that holds wafer W is arranged. Wafer holder 70 is equipped with a plate-shaped main section, and an auxiliary plate that is fixed to the upper surface of the main section and has a circular-shaped opening formed in its center portion, a diameter of the opening being around 2mm larger than a diameter of wafer W. In an area of the main section inside the circular-shaped opening of the auxiliary plate, multiple pins are placed and wafer W is vacuum-sucked in a state of being supported by the multiple pins. In this case, in the state where wafer W is vacuum-sucked, a height of the surface of wafer W and a height of the surface of the auxiliary plate are substantially the same.

Further, the position of wafer table WTB is detected by an interferometer 18 that is placed outside, via a movable mirror 17X arranged on the upper surface end section of wafer table WTB, at a resolution of, for example, around 0.5 to 1 nm. In this case, in actual, on the upper surface of wafer table WTB, an X movable mirror having a reflection surface orthogonal to the X-axis and extending in the Y-axis direction is arranged at one end (a -X side end) of the X-axis direction, and a Y movable mirror having a reflection surface orthogonal to the Y-axis and extending in the X-axis direction is arranged at one end (a +Y side end) of the Y-axis direction. An interferometer beam (a measurement beam) from the X-axis interferometer and the Y-axis interferometer is respectively projected to the reflection surface of each movable mirror, and by each interferometer receiving a reflected beam from the reflection surface, a displacement in the measurement direction from a datum position of each reflection surface (in general, a fixed mirror is placed on the side surface of projection unit PU or the side surface of an off-axis alignment system (not shown), which serves as a datum surface) is detected. The Y-axis interferometer has a measurement axis that is parallel to the Y-axis that connects a projection center (optical axis AX) of projection optical system PL and a detection center of the alignment system, and the X-axis interferometer has a measurement axis that perpendicularly intersects with the measurement axis of the Y-axis interferometer at the projection center of projection optical system PL.

The Y-axis interferometer is a multiaxis interferometer that has at least three optical axes, and an output value of each optical axis can be separately measured. The output values (the measurement values) of the Y-axis interferometer are supplied to main controller 20, and based on the output values from the Y-axis interferometer, main controller 20 can measure not only the position in the Y-axis direction (a Y-position) of wafer table WTB but also a rotation amount around the X-axis (a pitching amount) and a rotation amount around the Z-axis (a yawing amount). Further, the X-axis interferometer is a multiaxis interferometer that has at least two optical axes, and an output value of each optical axis can be separately measured. The output values (the measurement values) of the X-axis interferometer are supplied to main controller 20, and based on the output values from the X-axis interferometer, main controller 20 can measure not only the position in the X-axis direction (an X-position) of wafer table WTB but also a rotation amount around the Y-axis (a rolling amount).

As is described above, on wafer table WTB, in actual, the X-axis movable mirror and the Y-axis movable mirror are arranged, and the X-axis interferometer and the Y-axis interferometer are arranged corresponding to the movable mirrors. However, in FIG. 1, they are representatively shown by movable mirror 17 and interferometer 18. Incidentally, for example, an end surface of wafer table WTB may be polished in order to form a reflection surface (corresponding to the reflection surface of movable mirror 17).

Next, the configuration of the vicinity of a lower end portion of projection unit PU will be described.

The lowermost lens 92 inside barrel 40 is made of materials such as a silica glass, a fluorine-doped quartz, or a fluoride crystal (such as a fluorite or a lithium fluoride) , and is a planoconvex lens whose lower end surface is a plane surface and upper surface is spherical (or aspherical). In the vicinity of the outer edge of lens 92, an inclined surface is formed around the entire circumference. And, as is shown in the section view in FIG. 2, lens 92 is fixed in a state where the inclined surface is supported from below by a taper section at a lower end portion of barrel 40. At a lower end of barrel 40, a seal member 43 having a ring shape is arranged.

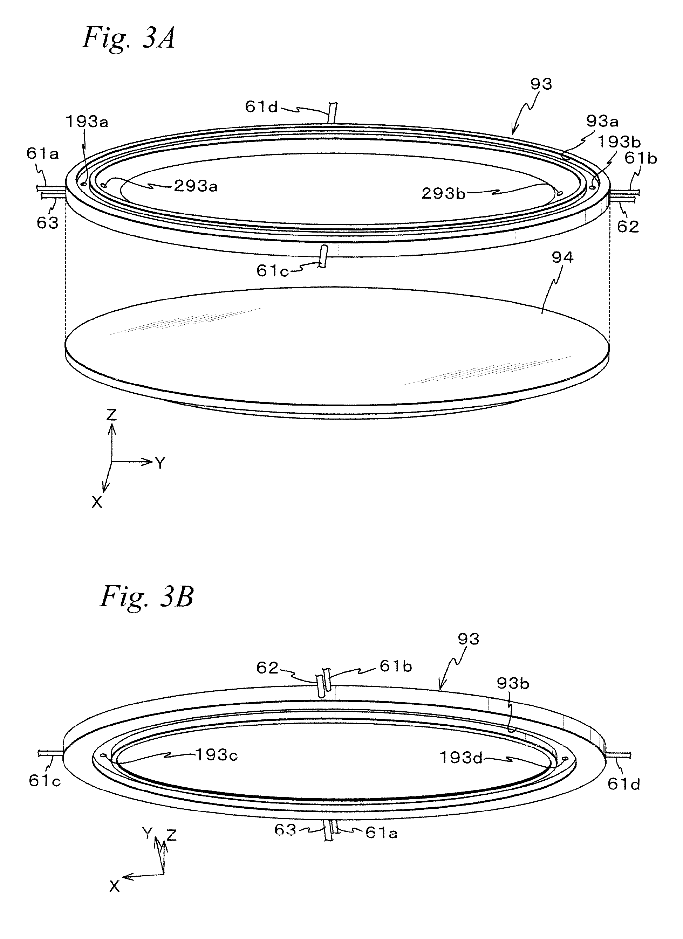

As is shown in FIG. 3A that is a perspective view viewed from obliquely upward and FIG. 3B that is a perspective view viewed from obliquely downward, spacer member 93 has an annular shape having a substantially trapezoidal cross-section shape (refer to FIG. 2), and is made of nonmetal materials (such as a silica glass, or a low thermal-expansion ceramic) having a coefficient of thermal expansion close to that of, for example, a silica glass that is a lens material. On the upper end surface of spacer member 93, a first groove 93a that is made up of a depression groove is formed around the entire circumference, and on the lower end surface, a second groove 93b that is similar to first groove 93a is formed.

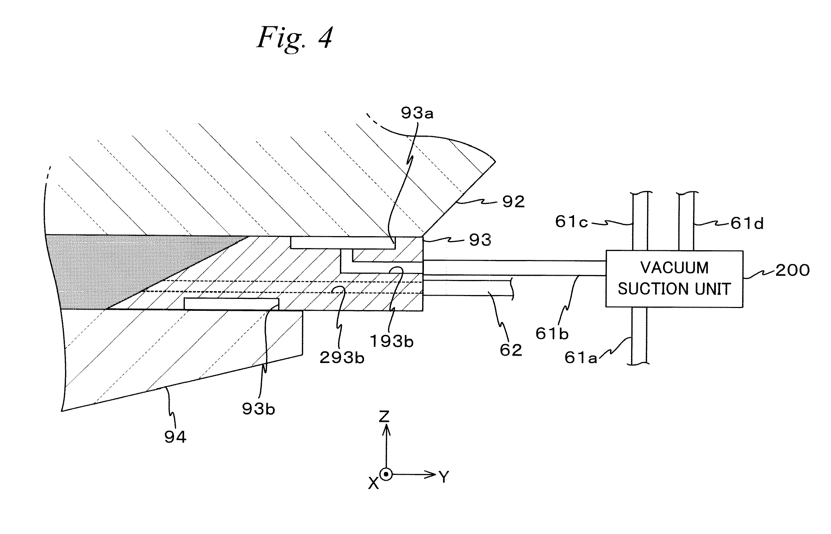

Below first groove 93a in the vicinity of an end portion of spacer member 93 on a +Y side, a vent path 193b having an L-like cross-section shape is formed, as is shown in a section view of FIG. 4, and one end of vent path 193b is opened to the inner bottom surface of first groove 93a. The other end of vent path 193b is opened to the outer circumference surface of spacer member 93. To the other end of vent path 193b, one end of a vacuum suction pipe 61b is connected. The other end of vacuum suction pipe 61b is connected to a vacuum suction unit 200.

Also, below first groove 93a in the vicinity of an end portion of spacer member 93 on a -Y side, a vent path 193a similar to vent path 193b is formed symmetrically, and one end of vent path 193a is opened to the inner bottom surface of first groove 93a. To an opening end of vent path 193a on the other end side, one end of a vacuum suction pipe 61a is connected, and the other end of vacuum suction pipe 61a is connected to vacuum suction unit 200 described above (refer to FIG. 4).

Above second groove 93b in the vicinity of an end portion of spacer member 93 on a +X side and -X side, vent paths 193c and 193d having an L-shape similar to vent 193b are formed respectively, and one ends of vent paths 193c and 193d are respectively opened to the inner bottom surface of second groove 93b, as is shown in FIG. 3B. To the other end of each of vent paths 193c and 193d, one ends of vacuum suction pipes 61c and 61d are connected respectively, and the other ends of vacuum suction pipes 61c and 61d are connected to vacuum suction unit 200 described above.

In the embodiment, a vacuum suction mechanism, which can generate the negative pressure within vent paths 193a to 193d and first and second grooves 93a and 93b formed at spacer member 93, is configured of vacuum suction pipes 61a to 61d and vacuum suction unit 200

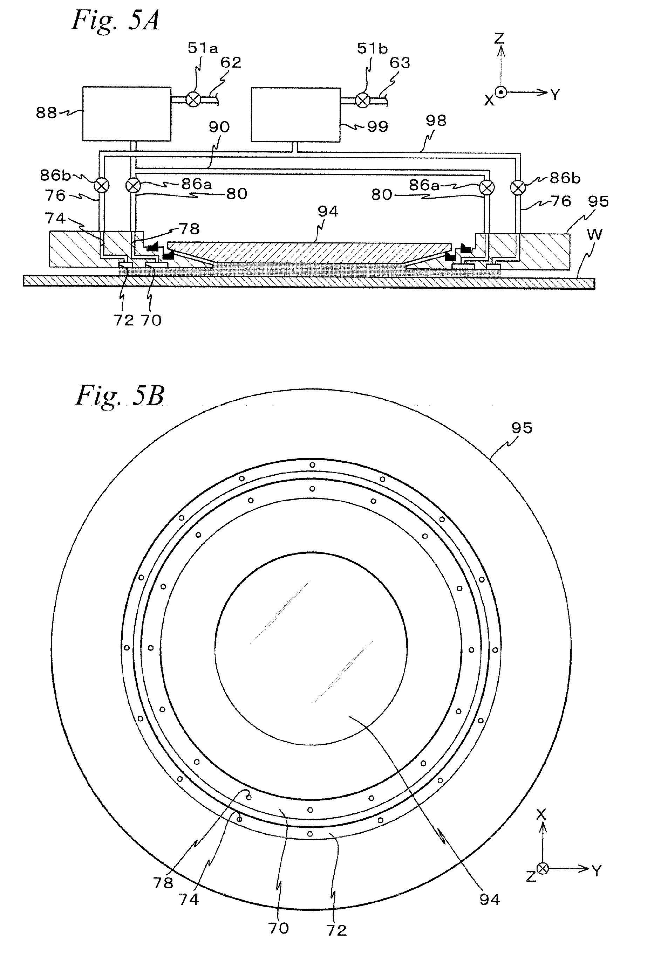

At spacer member 93, as is shown in FIGS. 3A and 4, a flow path 293b that lies from an outer side of the outer circumference to an inner side of the inner circumference in the radius direction is formed. To one end of flow path 293b, one end of a liquid supply pipe 62 is connected, and the other end side of liquid supply pipe 62 is connected to a liquid supply unit 88 (not shown in FIG. 4, refer to FIG. 5A). Liquid supply unit 88 is configured including a liquid tank, a pressure pump and a temperature controller. The temperature controller adjusts the temperature of a liquid within the liquid tank to the approximately same temperature with the temperature within a chamber (not shown) in which the exposure apparatus main section is housed. Further, at a part of liquid supply pipe 62, a valve 51a used to control the supply/stop of a liquid is arranged. Incidentally, as valve 51a, for example, a flow control valve is preferably used so that not only the supply/stop of a liquid but also the adjustment of a flow rate can be performed. Further, valve 51a may be arranged inside liquid supply unit 88.

Meanwhile, as is shown in FIG. 3A, a flow path 293a is formed at the position on a side opposite to flow path 293b of spacer member 93 (the position being symmetric with respect to a point). In this case, as can be seen from FIG. 3A, an opening end of flow path 293a is formed at a position higher in the gravity direction than an opening end of flow path 293b. To one end of flow path 293a, a liquid recovery pipe 63 is connected, and the other end side of liquid recovery pipe 63 is connected to a liquid recovery unit 99 (not shown in FIG. 3A, refer to FIG. 5A) that is configured including a liquid tank and a suction pump. At a part of recovery supply pipe 63, a valve 51b used to control the recovery/stop of a liquid is arranged. As valve 51b , a flow control valve is preferably used so as to correspond to the valve on a side of the liquid supply unit described above. Incidentally, valve 51b may be arranged inside liquid recovery unit 99.

In this case, as the liquid, ultrapure water that transmits an ArF excimer laser beam (light with a wavelength of 193nm)(hereinafter simply referred to as 'water' except for the case specifying is necessary) is to be used. Ultrapure water can be obtained in large volume in semiconductor factories and the like without difficulty, and also has the advantage of having no adverse effect to photoresist on a wafer, an optical lens and the like.

As is shown in FIG. 3A, parallel flat plate 94 is a member having a discoid shape as a whole that has the upper surface and the lower surface being parallel planes, and made of a fluoride crystal such as a fluorite or a lithium fluoride similar to lens 92. At the outer edge portion of the lower surface of parallel flat plate 94, an inclined section (a taper section) is formed along the entire circumference direction (refer to FIG. 2 and the like).

In the embodiment, as is described above, since vacuum suction unit 200 is connected to spacer member 93 via vacuum suction pipes 61a to 61d, vacuum suction unit 200 operates in a state where spacer member 93 is disposed between the lower surface (the plane surface) of lens 92 and the upper surface (the plane surface) of parallel flat plate 94 as is shown in FIG. 2, thereby generating the negative pressure inside vent paths 193a to 193d and inside first and second grooves 93a and 93b, and making spacer member 93 vacuum-suck the periphery portion of lens 92 and the periphery portion of parallel flat plate 94. In this manner, parallel flat plate 94 is supported by lens 92 via spacer member 93.

Further, since spacer member 93 is a member having an annular shape, the space enclosed by lens 92, spacer member 93 and parallel flat plate 94 becomes a closed space 21 (refer to FIG. 2). Since a liquid (water) is held within closed space 21, closed space 21 is referred to as liquid room 21 hereinafter. In the embodiment, liquid (water) Lq2 is held in liquid room 21 in the manner described below.

That is, main controller 20 (refer to FIG. 1) opens valve 51a that is connected to liquid supply pipe 62 to a predetermined degree and starts supply of water into liquid room 21 via flow path 293b. Then, prior to liquid room 21 being filled with water, main controller 20 opens valve 51b that is connected to liquid recovery pipe 63 to a predetermined degree and starts recovery of water from liquid room 21 to the inside of liquid recovery unit 99 (the liquid tank) via flow path 293a (refer to FIG. 5). On these operations, main controller 20 makes the quantity of water supplied to liquid room 21 constantly equal the quantity of water recovered from liquid room 21. Accordingly, a constant quantity of water Lq2 (refer to FIG. 2) is held within liquid room 21. In this case, water Lq2 held within liquid room 21 is constantly replaced. Further, in the embodiment, since water is supplied from the vicinity of a lower end portion of liquid room 21 and is recovered from the vicinity of an upper end portion of liquid room 21, air within liquid room 21 is simultaneously recovered when water is recovered, which makes it possible to fill the inside of liquid room with water without fail.

Around parallel flat plate 94, as is shown in FIG. 2, an annular member 95 is arranged in a state of surrounding parallel pate 94 and spacer member 93. To be more specific, annular member 95 is suspended by, for example, a holding member that holds projection unit PU via a support member (not shown) in a state where the tip portion (the end portion on the inner circumference side) of annular member 95 is inserted between the taper section described above of parallel flat plate 94 and wafer W and also in a state where the bottom surface of annular member 95 is parallel to the XY plane. Thus, a positional relation between projection optical system PL and annular member 95 with respect to an optical axis AX direction (the Z-axis direction) of projection optical system PL is maintained to a constant relation.

Further, at annular member 95 in a state of FIG. 2, a step section that fits to (engages with) the vicinity of the outer periphery of spacer member 93 from below via a predetermined clearance is formed in the vicinity of the upper end surface on a side of the inner circumference of annular member 95. On the upper surface of the step section of annular member 95, a seal member 42 having an annular shape that is pressed against the lower surface of spacer member 93 is arranged. Further, on the inner circumference side of the step section on the upper surface of annular member 95, a seal member 41 having an annular shape that is pressed against to the taper section of parallel flat plate 94 from below is arranged. In this case, in the case a vacuum suction force by spacer member 93 is released, spacer member 93 and parallel flat plate 94 are supported from below by annular member 95 via seal members 42 and 41 respectively.

At the bottom surface of annular member 95, though being omitted in FIG. 2 but as can be seen when viewing FIG. 5A and a bottom plan view of annular member 95 in FIG. 5B together, a water supply groove 70 having an annular shape and a drainage groove 72 having an annular shape are sequentially formed from the inside to the outside and also concentrically formed. Incidentally, in FIG. 5A and FIG. 5B, of two grooves 71 and 72, a groove width of water supply groove 70 is set to wider than that of drainage groove 72.

On the inner bottom surface of water supply groove 70 (the inner upper surface in FIG. 5A), a through-hole 78 that runs through in the vertical direction is formed in plural substantially equally spaced, and one end of a water supply pipe 80 is connected to each through-hole 78 respectively from above. The other end of each water supply pipe 80 is respectively connected to one end of a supply pipe line 90 respectively via valve 86a, the other end of supply pipe line 90 being connected to liquid supply unit 88 described above. In this case, when liquid supply unit 88 operates in a state where corresponding vale 86a is opened, for example, a liquid for liquid immersion whose temperature is adjusted by the temperature controller to the approximately same temperature as the temperature within the chamber (not shown) where (the main section of) exposure apparatus 100 is housed is supplied into water supply groove 70 of annular member 95 sequentially via supply pipe line 90, water supply pipe 80 and through-hole 78. Incidentally, in the following description, valves 86a arranged at respective water supply pipes 80 are also described as valve group 86a.

As the liquid for liquid immersion described above, ultrapure water that transmits an ArF excimer laser beam (light with a wavelength of 193nm) like liquid Lq2 described above is to be used. Refractive index n of water is said to be around 1.44. In the water, the wavelength of illumination light IL is 193nm x 1/n, shortened to around 134nm. Further, since ultrapure water has no adverse influence on the environment and also has an extremely low content of impurities, the effect can also be expected that cleans a surface of a wafer and a surface of parallel flat plate 94.

On the inner bottom surface of drainage groove 72 (the inner upper surface in FIG. 5A), a through-hole 74 that runs through in the vertical direction is formed in plural substantially equally spaced, and one end of a drainage pipe 76 is connected to each through-hole 74 respectively from above. The other end of each drainage pipe 76 is respectively connected to one end of a drainage line 98 respectively via valve 86b, the other end of drainage line 98 being connected to liquid recovery unit 99 described above. In this case, when corresponding vale 86b is in an opened state, water that exists in the vicinity of drainage groove 72 between the lower surface of annular member 95 and the surface of wafer W is recovered by liquid recovery unit 99 via drainage pipe 76. Incidentally, in the following description, valves 86b arranged at respective drainage pipes 76 are also described as valve group 86b.

In this case, as each valve of valve groups 86a and 86b, as described earlier, a regulating valve (e.g. a flow control valve) whose open degree can be adjusted besides the opening/closing, or the like is used.

Next, the supply/drainage operation of water for liquid immersion will be described. In this case, wafer stage WST is assumed to be static.

First, main controller 20 starts water supply from liquid supply unit 88 to annular member 95 in a state where each valve of valve group 86a is opened to a predetermined degree, and also starts the operation of liquid recovery unit 99 in a state where each valve of valve group 86b is opened to a predetermined degree. With these operations, water having a predetermined pressure (positive pressure) is sent from liquid supply unit 88 into water supply groove 70 of annular member 95 via water supply pipe line 90 and each water supply pipe 80, and a part of the water that has been sent flows entirely inside water supply groove 70 of annular member 95, into the space between the lower surface of annular member 95 and wafer W, and into the space between parallel flat plate 94 and wafer W, and then is recovered by liquid recovery unit 99 via drainage groove 72 and each through-hole 74.

On these operations, main controller 20 sets the opened degree of each valve of valve groups 86a and 86b, the pressures of water supplied from liquid supply unit 88, the negative pressure that liquid recovery unit 99 generates inside each drainage pipe 76, and the like so that the quantity of water supplied to annular member 95 substantially equals the quantity of water drained from drainage groove 72. In this manner, a constant quantity of water is constantly sent to below parallel flat plate 94 and the water that has been sent is constantly recovered by liquid recovery unit 99.

Incidentally, another drainage groove may be formed on the inner side of water supply groove 70 on the bottom surface of annular member 95, and the inside of another drainage groove may be opened to the atmosphere via a pipe line (not shown). In this case, main controller 20 needs to set the opened degree of each valve of valve groups 86a and 86b, the pressure of water supplied from liquid supply unit 88, the negative pressure that liquid recovery unit 99 generates inside each drainage pipe 76, and the like so that the quantity of water supplied to annular member 95 is slightly larger than the quantity of water drained from drainage groove 72. In this manner, water that has been supplied to annular member 95 but has not been drained from drainage groove 72 fills the space between the lower surface of annular member 95 and wafer W and the space between parallel flat plate 94 and wafer W, and then drained to the outside via another drainage groove and the pipe line. In this case, since another drainage groove is a passive drainage groove that is opened to the atmosphere, the water pressure is hardly applied to parallel flat plate 94 and the stress is not generated.

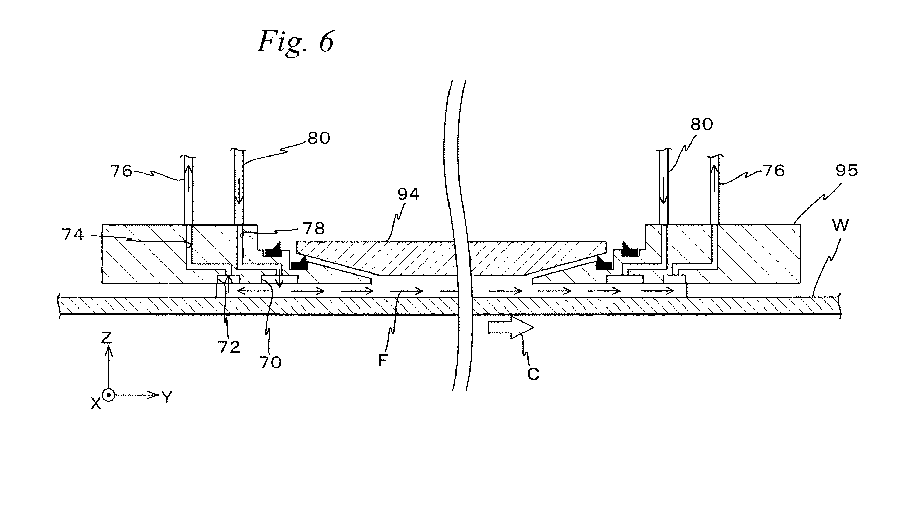

In either case, when wafer stage WST moves in a predetermined direction, for example, in a direction indicated by an arrow C in FIG. 6, a water flow indicated by an arrow F in the same drawing is generated below parallel flat plate 94. The flow indicated by arrow F is a laminar Couette flow that is generated by a shear force due to relative displacement of the surface of wafer W and the lower surface of parallel flat plate 94 is applied to the water, which is an incompressible viscous fluid and also a Newtonian fluid that is based on the viscosity law of Newton.

In exposure apparatus 100 of the embodiment, when wafer stage WST and wafer W are driven, for example, at the time of performing the stepping between shots of wafer stage WST (and wafer W) and at the time of scanning exposure, a laminar Couette flow in a direction corresponding to the drive direction is generated, and therefore water below parallel flat plate 94 is replaced.

In exposure apparatus 100 of the embodiment configured as is described above, like a normal scanning stepper, after predetermined preparatory operations such as reticle alignment using a reticle alignment system, an alignment detection system (none of which is shown) and the like, baseline measurement of the alignment detection system, and wafer alignment such as EGA (Enhanced Global Alignment) are performed, the exposure operation by a step-and-scan method is performed, and a pattern of reticle R is transferred to each shot area on wafer W. Incidentally, since each of these operations does not have different points in particular from a normal scanning stepper, except for the point that the reticle alignment and the exposure operation are performed in a state where liquid Lq2 is held within liquid room 21 and liquid Lq1 is held in the space between parallel flat plate 94 and wafer W, the detailed description will be omitted.

As is obvious from the description so far, in the embodiment, each through-hole 78 and water supply groove 70 formed at annular member 95 fulfill the function of a liquid supply nozzle, and each through-hole 74 and drainage groove 72 formed at annular member 95 fulfill the function of a liquid recovery nozzle. However, the configuration of the embodiment is merely an example, and a supply nozzle and a recovery nozzle as is disclosed in, for example, the Pamphlet of International Publication No. WO99/49504 may be arranged instead of annular member 95.

As is described above, in projection unit PU related to the embodiment, as a support structure of parallel flat plate 94 constituting projection unit PU, the support structure of the present invention is employed. In other words, parallel flat plate 94 is supported by lens 92 via spacer member 93, which is disposed between lens 92 that is located at the lowermost end of a plurality of lenses constituting projection optical system PL inside barrel 40 and parallel flat plate 94, and sucks the periphery portion of lens 92 and the periphery portion of parallel flat plate 94. In this case, since spacer member 93 sucks the facing surfaces of lens 92 and parallel flat plate 94 respectively, spacer member 93 does not protrude to the outside of lens 92 and parallel flat plate 94. Accordingly, parallel flat plate 94 can be supported by spacer member 93 without protruding spacer member 93 to the outside of parallel flat plate 94. With this configuration, the space in the vicinity of parallel flat plate 94 can be secured.

Further, since the method of supporting parallel flat plate 94 by spacer member 93 is a support method that makes use of a vacuum suction force, deformation of parallel flat plate 94 can be suppressed. Moreover, since parallel flat plate 94 can be detached without difficulty by releasing the suction force and it is easy to perform the exchange, parallel flat plate 94 can be exchanged relatively frequently.

Accordingly, in exposure apparatus 100 of the embodiment, for the reason described above, a pattern of reticle R is transferred onto wafer W using projection optical system PL whose image-forming performance is favorably maintained.

Further, since the space in the vicinity parallel flat plate 94 is secured, a member necessary for exposure, for example, a nozzle forming member such as annular member 95 described above can be placed in the space, which makes it possible to reduce a liquid immersion area in size. Thus, wafer table WTB can be downsized, and the position controllability of wafer table WTB is improved, and also in this regard, exposure accuracy can be improved.

Furthermore, in the exposure apparatus of the embodiment, exposure is performed in a state where a liquid immersion area is formed between parallel flat plate 94 and wafer W, via projection optical system PL that is in a state where water (liquid) is supplied to liquid room 21 formed between lens 92 and parallel flat plate 94, and therefore, exposure with high resolution and a larger depth of focus (NA>1) than in the air can be performed, and a pattern of reticle R can be transferred onto a wafer, which makes it possible to achieve transfer of , for example, a fine pattern having a device rule of around 70 to 100nm.

Further, in the embodiment, since an optical element closest to the image plane side of projection optical system PL is parallel flat plate 94, position setting of parallel flat plate 94 before and after the exchange can be performed without difficulty, and image-forming performance before and after the exchange hardly changes. Accordingly, also in this regard, favorable image-forming performance of projection optical system PL can be maintained.

Incidentally, in the embodiment above, water supply groove 70 and drainage groove 72 described above may be divided by partition walls to form a plurality of cells. By forming a plurality of cells in this manner, even in the case pressure change is generated at a cell corresponding to an edge portion of a wafer when annular member 95 is located above the edge portion, the pressure change can be prevented from affecting other cells.

Incidentally, in the embodiment above, parallel flat plate 94 is to be supported from below by annular member 95 via seal members 42 and 41. However, parallel flat plate 94 is not necessarily supported in this manner.

Incidentally, in the embodiment above, the case has been described where the present invention is employed in a liquid immersion exposure apparatus. However, the present invention is not limited to this, and can be employed in a normal exposure apparatus. In this case, in the case the resist coated on the surface of wafer W scatters, parallel flat plate 94 can prevent the resist from adhering to lens 92.

Incidentally, in the embodiment above, as an optical member placed on a lower side of lens 92, parallel flat plate 94 is employed. However, the present invention is not limited to this, and a lens may be employed instead of parallel flat plate 94. In this case, the vicinity of the periphery portion of the upper surface of the lens is processed to a plane, and the plane may be vacuum-sucked, or a holding member (a flange) is arranged at the lens and the flange portion may be vacuum-sucked.

Incidentally, in the embodiment above, the case has been described where spacer member 93 has an annular shape, however, the present invention is not limited to this. As spacer member 93, a single spacer member is not always have to be used, and for example, three spacer members are placed spaced apart a predetermined distance with respect to the periphery portion of an optical member, and parallel flat plate 94 may be supported by suspension at three points.

Furthermore, a vacuum suction force does not always have to be made to act on both between spacer member 93 and lens 92 and between spacer member 93 and parallel flat plate 94 as in the embodiment above. A vacuum suction force is made to act on either one, for exmpale, only between spacer member 93 and parallel flat plate 94 and the other may be fixed by screws or the like. In this case, a flange is arranged at the circumference of lens 92, and the flange may be fixed by screws or the like.

Incidentally, in the embodiment above, a vacuum suction force is used as a suction force. However, the present invention is not limited to this, and for example, an electrostatic force or a magnetic force may be used.

Incidentally, in the embodiment above, the case has been described where lens 92 located at the lowermost end that constitutes projection optical system PL is made to support parallel flat plate 94 by disposing spacer member 93 between them. However, the present invention is not limited to this, and spacer member 93 is disposed between one lens within projection optical system PL and the other lens placed below the one lens, and the one lens may be made to support the other lens.

Further, the support method of the present invention is not only employed in the case of supporting optical members constituting a projection optical system, but also may be employed in the case of supporting optical members constituting an illumination system.

Incidentally, in the embodiment above, ultrapure water (water) is used as a liquid, however, the present invention is not limited to this as matter of course. As the liquid, a liquid that is chemically stable, having high transmittance to illumination light IL and safe to use, such as a fluorine-containing inert liquid may be used. As such a fluorine-containing inert liquid, for example, Fluorinert (the brand name of 3M United States) can be used. The fluorine-containing inert liquid is also excellent from the point of cooling effect. Further, as the liquid, a liquid which has transmittance to illumination light IL and a refractive index as high as possible, and furthermore, a liquid which is stable against the projection optical system and the photoresist coated on the surface of a wafer (such as cedarwood oil) can also be used. Further, in the case the laser is used as a light source, fomblin oil may be selected.

Further, in the embodiment above, the recovered liquid may be reuse, and in this case, a filter that removes impurities from the recovered liquid is preferably arranged in a liquid recovery unit, a recovery pipe or the like.

Further, in the embodiment above, the case has been described where the present invention is applied to a scanning exposure apparatus by a step-and-scan method or the like, however, it is a matter of course that the application range of the present invention it not limited to this. That is, the present invention can also be applied to a projection exposure apparatus by a step-and-repeat method, further to an exposure apparatus by a step-and-stitch method, an exposure apparatus by a proximity method or the like.

The usage of the exposure apparatus is not limited to the exposure apparatus used for manufacturing semiconductor devices. The present invention can be widely applied also to, for example, an exposure apparatus for manufacturing liquid crystal displays which transfers a liquid crystal display device pattern onto a square-shaped glass plate, and to an exposure apparatus for manufacturing organic EL, thin-film magnetic heads, imaging devices (such as CCDs) , micromachines, DNA chips or the like. Further, the present invention can also be applied to an exposure apparatus that transfers a circuit pattern onto a glass substrate or a silicon wafer not only when producing microdevices such as semiconductors, but also when producing a reticle or a mask used in an exposure apparatus such as an optical exposure apparatus, an EUV exposure apparatus, an X-ray exposure apparatus, and an electron beam exposure apparatus.

Incidentally, in the exposure apparatus of the embodiment above, illumination light IL is not limited to the ArF excimer laser beam, and a pulse laser beam such as a KrF excimer laser beam (wavelength: 248nm), an F₂ laser beam (wavelength: 157nm), an Ar₂ laser beam (wavelength: 126nm) or a Kr₂ laser beam (wavelength: 146nm), or an emission line such as a g-line (wavelength: 436nm) or an i-line (wavelength: 365nm) from an extra-high pressure mercury lamp can also be used. Further, a harmonic wave of a YAG laser, or a harmonic wave, which is obtained by amplifying a single-wavelength laser beam in the infrared or visible range emitted by a DFB semiconductor laser or fiber laser, with a fiber amplifier doped with, for example, erbium (or both erbium and ytteribium), and by converting the wavelength into ultraviolet light using a nonlinear optical crystal, may also be used. Further, the projection optical system is not limited to a reduction system, and may be either an equal magnifying system or a magnifying system.

Further, in the embodiment above, illumination light IL of the exposure apparatus is not limited to the light having a wavelength equal to or more than 100nm, and it is needless to say that the light having a wavelength less than 100nm may be used. For example, in recent years, in order to expose a pattern equal to or less than 70nm, an EUV exposure apparatus that makes an SOP, or a plasma laser as a light source generate an EUV (Extreme Ultraviolet) light in a soft X-ray range (e.g. a wavelength range from 5 to 15 nm) , and uses a total reflection reduction optical system designed under the exposure wavelength (e.g. 13.5nm) and the reflective type mask has been developed. In the EUV exposure apparatus, the arrangement in which scanning exposure is performed by synchronously scanning a mask and a wafer using a circular arc illumination can be considered.

Further, the present invention can also be applied to an exposure apparatus that uses charged particle beams such as an electron beam or an ion beam. Incidentally, an electron beam exposure apparatus may employ any of the pencil beam method, variable beam shaping method, cell projection method, blanking aperture array method, and mask projection method. For example, in an exposure apparatus that uses an electron beam, an optical system equipped with an electromagnetic lens is used, and this optical system constitutes an exposure optical system and an exposure optical system unit is configured including a barrel of the exposure optical system and the like.

Incidentally, semiconductor devices are manufactured through the following steps: a step where the function/performance design of a device is performed; a step where a reticle based on the design step is manufactured; a step where a wafer is manufactured using materials such as silicon; a lithography step where a pattern formed on a reticle as a mask is transferred onto a photosensitive object by the exposure apparatus of the embodiment above; a device assembly step (including a dicing process, a bonding process, and a packaging process); inspection step, and the like. In this case, in the lithography step, because the exposure apparatus in the embodiment above is used, high integration devices can be manufactured with good yield.

As is described above, the support method and support structure of an optical member of the present invention are suitable to support optical members. Further, the optical unit of the present invention is suitable to be used as a projection optical system constituting an exposure apparatus. Further, the exposure apparatus of the present invention is suitable to transfer a pattern formed on a mask onto an object. Further, the device manufacturing method of the present invention is suitable to manufacture microdevices.

## Claims

1. A support method of an optical member, comprising:
disposing a spacer member between a first optical member and a second optical member; and
making the first optical member support the second optical member via the spacer member by sucking at least one of at least a part of a periphery portion of the first optical member and at least a part of a periphery portion of the second optical member by the spacer member.

2. The support method of an optical member according to Claim 1 wherein
the spacer member vacuum-sucks at least one of at least a part of a periphery portion of the first optical member and at least a part of a periphery portion of the second optical member.

3. The support method of an optical member according to Claim 1 wherein
the spacer member sucks at least one of at least a part of a periphery portion of the first optical member and at least a part of a periphery portion of the second optical member, by one of an electrostatic force and a magnetic force.

4. A support structure of an optical member, comprising:
a spacer member that is disposed between a periphery portion of a first optical member and a periphery portion of a second optical member, and makes the first optical member support the second optical member by sucking at least one of at least a part of a periphery portion of the first optical member and at least a part of a periphery portion of the second optical member.

5. The support structure of an optical member according to Claim 4 wherein
the spacer member vacuum-sucks at least one of at least a part of a periphery portion of the first optical member and at least a part of a periphery portion of the second optical member.

6. The support structure of an optical member according to Claim 4 wherein
the spacer member sucks at least one of at least a part of a periphery portion of the first optical member and at least a part of a periphery portion of the second optical member, by one of an electrostatic force and a magnetic force.

7. An optical unit that includes a plurality of optical members, the unit comprising:
a spacer member that is placed between a periphery portion of a first optical member and a periphery portion of a second optical member among the plurality of optical members, and makes the first optical member support the second optical member by sucking at least one of at least a part of a periphery portion of the first optical member and at least a part of a periphery portion of the second optical member.

8. The optical unit according to Claim 7, further comprising:
a vacuum suction mechanism that is connected to the spacer member and sucks at least one of at least a part of a periphery portion of the first optical member and at least a part of a periphery portion of the second optical member by generating a negative pressure within a vent path formed at the spacer member.

9. The optical unit according to Claim 7, further comprising:
a suction mechanism that sucks at least one of at least a part of a periphery portion of the first optical member and at least a part of a periphery portion of the second optical member, by one of an electrostatic force and a magnetic force.

10. An exposure apparatus that projects an image of a predetermined pattern on an object, the apparatus comprising:
a stage on which the object is mounted; and
the optical unit according to any one of Claims 7 to 9 that projects an image of the pattern on the object.

11. The exposure apparatus according to Claim 10 wherein
the second optical member is an optical member that is located closest to an image plane side among the plurality of optical members.

12. The exposure apparatus according to Claim 11, further comprising:
a liquid immersion unit that forms a liquid immersion area filled with a liquid between the second optical member and the object.

13. The exposure apparatus according to Claim 12 wherein the second optical member is a parallel flat plate.

14. The exposure apparatus according to Claim 12 wherein
the liquid immersion unit has a supply nozzle that supplies the liquid to a space between the second optical member and the object, and a recovery nozzle that recovers the liquid from the space between the second optical member and the object.

15. The exposure apparatus according to Claim 14 wherein
a tip portion of at least one of the supply nozzle and the recovery nozzle is inserted between the second optical member and the object.

16. The exposure apparatus according to Claim 14 wherein the spacer member has an annular shape, and
a space formed by the first optical member, the second optical member and the spacer member is filled with a liquid.

17. The exposure apparatus according to Claim 16 wherein
a flow path used to supply the liquid from the outside to the space is formed at the spacer member.

18. The exposure apparatus according to Claim 16 wherein
a supply flow path used to supply the liquid from the outside to the space and a recovery flow path used to recover the liquid from the space are formed at the spacer member, and
an opening end of the supply flow path is arranged on a lower side in a gravity direction than an opening end of the recovery flow path.

19. The exposure apparatus according to Claim 16 wherein
the supply nozzle and the recovery nozzle are respectively formed at an annular-shaped member whose end portion on an inner circumference side is inserted between the second optical member and the object, and
a seal member having an annular shape that isolates the space from the outside is arranged between the annular member and at least one of the second optical member and the spacer member.

20. The exposure apparatus according to Claim 19 wherein
the annular member supports at least one of the second optical member and the spacer member via the seal member when suction by the spacer member of at least one of the first optical member and the second optical member is released.

21. A device manufacturing method that includes a lithography process in which a device pattern is transferred onto an object using the exposure apparatus according to Claim 10.
